Europäisches Patentamt

European Patent Office

Office européen des brevets

(11) Publication number : **0 484 021 A1**

# (12) EUROPEAN PATENT APPLICATION

(21) Application number : **91309659.0**

(22) Date of filing : **18.10.91**

(51) Int. Cl.$^5$ : **G03F 7/039**, G03F 7/075,
C08F 2/50, C08F 20/18,
C08F 12/22

(30) Priority : **19.10.90 JP 282414/90**
**22.03.91 JP 58738/91**

(43) Date of publication of application :
**06.05.92 Bulletin 92/19**

(84) Designated Contracting States :
**DE FR GB IT NL**

(71) Applicant : **NIPPON PAINT CO., LTD.**
**2-1-2, Oyodokita Kita-ku**
**Osaka-shi Osaka 530 (JP)**

(72) Inventor : **Ohata, Masatoshi**
**172-3, Fuseo**
**Sakai-shi, Osaka-fu (JP)**
Inventor : **Yamamoto, Masaharu**
**Aokaoka-Ryoe, 12-12, Aobaokaminami**
**Suita-shi, Osaka-fu (JP)**

(74) Representative : **Perry, Robert Edward et al**
**GILL JENNINGS & EVERY 53-64 Chancery**
**Lane**
**London WC2A 1HN (GB)**

(54) **Resist composition.**

(57) The present invention provides a positive type resist composition which has excellent photosensitivity in light decomposition. The composition comprises ;
    (a) a polymer having at least 70 % of isotactic construction, prepared from polymerizable monomers, at least a portion of which is a (meth)acrylate monomer having a group selected from the class consisting of a t-butyl group, a benzyl group, an alpha-methylbenzyl group, an alpha, alpha-dimethylbenzyl group and a trityl group, and
    (b) a photoactivator which generates an acid in response to a light irradiation.
    The present invention also provides a resist composition into which, instead of the polymer (a), a polymer (c) is formulated which has at least 70 % of isotactic construction and is prepared from polymerizable monomers, at least a portion of which is a hydroxyl styrene selected from the class consisting of p-t-butoxycarbonyloxystyrene, p-t-butoxycarbonyloxy-alpha-methyl-styrene, t-butyl-p-vinyl benzoate and t-butyl-p-isopropenylphenyloxy acetate.

EP 0 484 021 A1

FIELD OF THE INVENTION

The present invention relates to a resist composition which comprises a highly stereoregulated polymer and a photoactivator which generates an acid in response to a light irradiation. More particularly, it relates to a resist composition which has excellent photosensitivity and is suitable for printing plates, photoresists of integrated circuit boards or color filters and the like.

BACKGROUND OF THE INVENTION

Resist compositions are classified into two groups, one is a negative type which cures a portion on which light is irradiated, and the other is a positive type which elutes away a portion on which light is irradiated. The positive type resist compositions are more suitable for litho printing plates or resists for integrated circuit boards, because they have superior resolving power in comparison with the negative type one.

The positive type resist compositions which have been used are based on the reaction that quinonediazide groups are decomposed by light to change to indene carboxylic acids through ketene compounds. The indene carboxylic acids cause elution with alkali solution. The compositions, however, have poor sensitivity in light decomposition and poor operating efficiency because it takes long time to expose to light.

Japanese Kokai Publication 59-45439 (corresponding to USP 4,491,628) discloses a resin composition which comprises a polymer (e.g. polystyrene) repeatedly having groups, such as t-butyl esters or t-butyl carbonates, and a photopolymerization initiator. Upon irradiating ultraviolet onto the resin composition, the photopolymerization initiator generates acids which change the t-butyl esters or t-butyl carbonates to corresponding base-soluble phenols or base-soluble carboxylic acids, which are developable with a basic solution. The composition, however, does not have sufficient photosensitivity for printing and photoresists of color filters or integrated circuit boards.

SUMMARY OF THE INVENTION

The present invention provides a positive type resist composition which has excellent photosensitivity in light decomposition. The composition comprises;

(a) a polymer having at least 70 % of isotactic construction, prepared from polymerizable monomers, at least a portion of which is a (meth)acrylate monomer having a group selected from the class consisting of a t-butyl group, a benzyl group, an alpha-methylbenzyl group, an alpha, alpha-dimethylbenzyl group and a trityl group, and

(b) a photoactivator which generates an acid in response to a light irradiation.

The present invention also provides a resist composition into which, instead of the polymer (a), a polymer (c) is formulated which has at least 70 % of isotactic construction and is prepared from polymerizable monomers, at least a portion of which is a hydroxylstyrene selected from the class consisting of p-t-butoxycarbonyloxystyrene, p-t-butoxycarbonyloxy-alpha-styrene, t-butyl-p-vinyl benzoate and t-butyl-p-iopropenylphenyloxy acetate.

DETAILED DESCRIPTION OF THE INVENTION

The polymer (a) or (c) of the present invention is highly stereoregulated and isotactic. The polymer may be prepared by anionic polymerization, especially living anionic polymerization.

The polymer (a) is prepared from (meth)acrylic ester monomers having a group selected from the class consisting of a t-butyl group, a benzyl group, an alpha-methylbenzyl group, an alpha, alpha-dimethylbenzyl group and a trityl group and optionally copolymerizable alpha, beta-ethylenic monomers. Typical examples of the (meth)acrylic ester monomers are t-butyl (meth)acrylate, benzyl (meth)acrylate, alpha-methylbenzyl (meth)acrylate, alpha, alpha-dimethylbenzyl (meth)acrylate, trityl (meth)acrylate and the like.

The polymer (c) is prepared from hydroxylstyrene monomers and optionally copolymerizable alpha, beta-ethylenic monomers. The hydroxylstyrene monomers are selected from the class consisting of p-t-butoxycarbonyloxystyrene, p-t-butoxycarbonyloxy-alpha-styrene, t-butyl-p-vinyl benzoate and t-butyl-p-iopropenylphenyloxy acetate.

The copolymerizable alpha, beta-ethylenic monomers are not limited, but for example (meth)acrylates, such as methyl (meth)acrylate, ethyl (meth)acrylate, n-butyl (meth)acrylate, propyl (meth)acrylate, isopropyl (meth)acrylate and phenyl (meth)acrylate; styrenes, such as styrene, p- or m-methylstyrene, alpha-methylstyrene, p- or m-chlorostyrene and p- or m-bromostyrene; and the like. These monomers may be used solely or in combination. The copolymerizable monomers may be used in an amount 0 to 30 % by weight based on the essential monomers.

The anionic polymerization may be initiated by an anionic polymerization initiator which is not limited, but for example an organic alkali metal compound, such as n-butyllithium, sec-butyllithium, tert-butyllithium, 1,1-diphenylhexyl lithium, cumylpotassium and cumylcesium; an organic magnesium halide, such as sec-butyl magnesium chloride, tert-butyl magnesium chloride, benzyl magnesium chloride, sec-butyl magnesium bromide, t-butyl magnesium bromide and benzyl magnesium bromide; a mixture thereof; and the like. An amount of the initiator only depends on the molecular weight of polymer which is to prepare.

The polymerization reaction may be conducted at a temperature of -80 to -100 °C in an inert gas atmosphere or under a reduced pressure, preferably in vacuo. The reaction may be conducted in a solvent which is inactive to the polymerization reaction. Examples of the solvents are aromatic hydrocarbons, such as benzene, toluene, xylene and ethylbenzene; alicyclic hydrocarbons, such as cyclohexene; aliphatic hydrocarbons, such as n-hexane; others, such as tetrahydrofuran, 1,4-dioxane, diethyl ether; mixtures thereof; and the like. A polymerization concentration is not limited, but generally within the range of 1 to 20 % by weight. A time for the polymerization reaction is not limited and can be varied based on monomer, polymerization degree and polymerization temperature, but generally from 1 minute to 72 hours.

In order to control the activity of the growing terminal of the polymer, a tertiary amine (e.g. tetramethylethylenediamine, dipiperidinoethane, triethylamine and N-methylpyrrolidone), a crown ether (e.g. 12-crown-4 and 15-crown-5) and a salt having the same ion as the counter cation of the growing terminal (lithium chloride, sodium chloride, potassium chloride and cesium chloride) may be empoled. An amount of these compounds is not limited, but generally 1 to 10 times mol based on the mol of the growing terminal.

After finishing the polymerization, the living terminals can be deactivated by contacting with a proton doner or an alkylsilyl halide. Typical examples of the proton doners are water and alcohols, such as methanol, ethanol and phenol. Examples of the alkylsilyl halides are trimethylsilyl chloride and the like. These compounds can be added solely or in combination.

The polymer (a) or (c) thus obtained has at least 70 %, preferably at least 80 % of isotactic construction, based on all construction of the polymer. If it is less than 70 %, the resist composition has poor photosensitivity in light decomposition. The polymer (a) or (c) preferably has a number average molecular weight of 1,000 to 1,000,000, more preferably 10,000 to 200,000. If the molecular weight is outside the above range, it is difficult to control the polymerization temperature or to purify the monomer or the solvent. The composition also does not have sufficient film-forming properties when made film, and poor solubility with an alkali solution.

It is preferred that the polymer (a) does not have a cyano group (-CN) or nitrile group. The cyano group generally contains in a polymer which prepared by a radical polymerization using a cyano group-containing initiator (e.g. azobisisobutylonitrile). It has been found that the cyano group has a function which inhibits the attacking reaction of the acid generated in response to light to the branched groups which is unstable against acid to decompose to release carboxyl groups or phenolic acid groups. It is also preferred that the polymer (a) does not have a unsaturated group in polymer ends. The unsaturated group is seemed to be introduced by disproportionation. It has also been found that the unsaturated group also inhibits the attacking reaction of the acid.

It is further preferred that the polymer has an alkoxysilyl group represented by;

$$-Si(R^1)_n(OR^2)_{3-n}$$

wherein $R^1$ and $R^2$, the same or different, a lower alkyl group preferably having 1 to 4 carbon atoms (such as methyl, ethyl, propyl, iso-propyl, t-butyl etc.) and n is 0, 1 or 2. The polymer (a) has poor adhesive properties with a substrate which is present under the photoresist and the like, because the polymer generally does not contain any functional groups which chemically or mechanically bond with the substrate. It has been found that the alkoxysilyl group significantly improves the adhesive properties with the substrate. The introduction of the alkoxysilyl group may be conducted by reacting an alkoxysilyl compound with a living terminal which is not deactivated after producing the polymer (a). Typical examples of the alkoxysilyl compounds are alkoxysilyl halides, such as trimethoxysilyl chloride, triethoxysilyl chloride, isopropoxydimethylsilyl chloride, t-butoxydimethylsilyl chloride, diisopropoxymethyl chloride and the like. An amount of the alkoxysilyl compound is not limited, but generally within the range of 1 to 1.5 equivalent besed on the living terminal. Amounts of more than 1.5 equivalent have disadvantages in economical viewpoint and produce hydrogen halide gas by reacting the remaining alkoxysilyl compound with water. The reaction conditions is the same as the polymerization. The polymer (a) having the alkoxysilyl groups has good adhesive properties and therefore can be used as an adhesive agent for photoresists solely or in combination with other additives. The additives include a hydrolysis promoter, such as an acid (e.g. acetic acid, alkylphosphate, diluted hydrochloric acid), a base (e.g. morphorine, t-butylammonium hydroxide); a solvent, such as a ketone (e.g. acetone, methyl ethyl ketone, cyclohexanone), an ester (e.g. ethyl acetate, butyl acetate, ethyleneglycol monoethyl ether), an ether (e.g. tetrahydrofuran, dioxane); and the like. The adhesive agent may be present between the photoresist layer and the substrate.

The resist composition of the present invention also contain a photoactivator (b) in addition to the polymer (a) or (c). The photoactivator (b) which generates an acid in response to a light irradiation may be an onium salt which is known to the art. Typical examples of the photoactivator are diaryliodonium salts, triarylsulfonium salts and triarylselenium salts. Preferred counter anions are metal complex halogenates, such as tetrafluoroborates, trifluoromethanesulfonate, hexafluoroantimonate, hexafluoroarsenate and hexafluorophosphate. These photoactivators (b) generate strong acids in response to a light irradiation, which attack the branched groups which are unstable against acid to decompose to release carboxyl groups or phenolic acid groups. The photoactivator may be present in the composition in an amount of 0.1 to 50 % by weight, preferably 1 to 30 % by weight, based on the weight of the polymer (a) or (c). Amounts of more than 50 % by weight reduce film strength and cost-up.

The resist composition may contain a photosensitizer in order to be sensitive with a light having wave lengths within ultraviolet to visible light. The photosensitizer includes polycyclic aromatic compounds, such as pyrene and perylene; other dyes, such as acrydine; and the like. An amount of the photosensitizer may be within the range of 0.01 to 10 % by weight, preferably 0.1 to 5 % by weight, based on the amount of the polymer (a) or (c).

The resist composition of the present invention may be prepared by mixing the above components. Mixing is conducted in the presence of a solvent or intact in a cool and dark place. Examples of the solvents are ketones, such as acetone, methyl ethyl ketone and cyclohexanone; esters, such as ethyl acetate, butyl acetate and ethyleneglycol acetate; ethers, such as tetrahydrofuran and dioxane; and the like.

The obtained composition is coated on a substrate and dried to form a resist layer. The layer is exposed to light through a positive film, and then developed. The substrate includes a steel panel, a surface-treated glass panel, a silicon wafer and the like. Coating may be conducted by rotating, bar coating, dipping, roll coating and the like. The light irradiation may be conducted using a light source, such as a ultrahigh pressure mercury lamp, a high pressure mercury lamp, a metal halide lamp, a xenone lamp, a low pressure mercury lamp and the like. An amount of irradiation dose is as much as 1.0 J/cm$^2$. The development can be conducted with an alkaline solution. Examples of the alkaline compounds for the developers are sodium hydroxide, potassium hydroxide, sodium carbonate, potassium carbonate, sodium metasilicate, potassium metasilicate and the like. The alkaline developer solution may contain the alkaline compound in an amount of 0.1 to 10 % by weight.

The resist composition of the present invention has excellent sensitivity to light and can be used even at a small light dose. It is very suitable for printing, color filters, integrated circuit boards and the like.

EXAMPLES

The present invention is illustrated by the following Examples which, however, are not construed as limiting the present invention to their details

Preparation of polymer

Preparation Example 1

The polymerization reaction was conducted by a breakable seal method in vacuo. A small amount of a benzene solution of 1,1-diphenylhexyl lithium was charged in a polymerization reaction vessel to rinse the vessel with the solution and the solution was removed. Then, 148 ml of toluene and 6.3 ml (0.806 mmol) of a benzene solution of 1,1-diphenylhexyl lithium was charged therein and cooled to -78 °C. To the content, 63 ml of a toluene solution of 140 mmol of t-butyl methacrylate was charged to start polymerization reaction. After mixing for 6 hours, 2 ml of methanol was added to terminate the reaction. Toluene in the reaction solution was removed and dissolved in acetone, which was charged in a large amount of a methanol and water mixture (1/1 vol %) to precipitate the reaction product. After drying the reaction product, it was purified by a reprecipitation method with an acetone and water mixture. The obtained polymer was 20.1 g (100 % yield), and had a number average molecular weight (GPC) of $4.0 \times 10^4$, an Mw/Mn ratio of 1.36 and a Tg of 79 °C.

The tacticity of the polymer was determined as follow. After dissolving 2.01 g of the polymer in 50.0 g of benzene and 50.2 g of methanol, 1.00 ml of trifluoromethanesulfonic acid was added and reacted at 57 °C for ten hours. After it was confirmed that the Bu$^t$-O absorption at 845 cm$^{-1}$ and the dimunal dimethyl at 1,365$^{-1}$ disappeared on IR spectra, the reaction mixture was added into diethyl ether to precipitate. It was then purified by reprecipitating with a methanol and diethyl ether mixture, and freeze-dried to obtain polymethacrylic acid. Subsequently, 0.200 g of the obtained polymethacrylic acid was swelled with 5 ml of methanol and 20 ml of benzene, into which 5 ml of a 10 % hexane solution of trimethylsilyl diazomethane was added and mixed at room temperature over night. The reacted solution was poured in a large amount of n-hexane to precipitate polymer. It was purified with a benzene and hexane solution, and freeze-dried to obtain polymethyl methacrylate. The polymer was subjected to $^1$H-NMR and $^{13}$C-NMR to obtain charts, from which the tacticity was calculated to find an isotact construction of about 100 %.

## Preparation Example 2

A reaction vessel was rinsed as generally described in Preparation Example 1. Then, 150 ml of toluene and 18.8 ml (2.41 mmol) of a benzene solution of 1,1-diphenylhexyl lithium was charged therein and cooled to -78 °C. To the content, 50 ml of a toluene solution of 133 mmol of t-butyl methacrylate was charged to start polymerization reaction. After mixing for 6 hours, 2 ml of methanol was added to terminate the reaction. The obtain polymer was treated as generally described in Preparation Example 1 and was 19.5 g (100 % yield), and had a number average molecular weight (GPC) of 2.0 X $10^4$, an Mw/Mn ratio of 1.25 and a Tg of 77 °C.

The tacticity of the polymer was determined as generally described in Preparation Example 1 to find an isotact construction of about 100 %.

## Preparation Example 3

A reaction vessel was rinsed as generally described in Preparation Example 1. Then, 185 ml of toluene and 16.4 ml (2.10 mmol) of a benzene solution of 1,1-diphenylhexyl lithium was charged therein and cooled to -78 °C. To the content, 72 ml of a toluene solution of 91 mmol of t-butyl methacrylate and 41 ml of a toluene solution of 34 mmol of methyl methacrylate were charged to start polymerization reaction. After mixing for 6 hours, 2 ml of methanol was added to terminate the reaction. The obtain polymer was treated as generally described in Preparation Example 1 and was 16.5 g (100 % yield), and had a number average molecular weight (GPC) of 1.2 X $10^4$ and an Mw/Mn ratio of 1.21.

The tacticity of the polymer was determined as generally described in Preparation Example 1 to find an isotact construction of 80 %, a heterotact construction of 16 % and a syndiotactic construction of 4 %.

## Preparation Example 4

A reaction vessel was rinsed as generally described in Preparation Example 1. Then, 84 ml of toluene, 1.8 ml (0.231 mmol) of a benzene solution of 1,1-diphenylhexyl lithium and 20 ml of a toluene solution of tetramethylethylenediamine were charged therein and cooled to -78 °C. To the content, 36 ml of a toluene solution of 21 mmol of t-butoxycarbonyloxystyrene was charged to start polymerization reaction. After mixing for 2 hours, 2 ml of methanol was added to terminate the reaction. The obtain polymer was treated as generally described in Preparation Example 1 and was 5.0 g (100 % yield), and had a number average molecular weight (GPC) of 2.8 X $10^4$ and an Mw/Mn ratio of 1.34

The tacticity of the polymer was determined as generally described in Preparation Example 1 to find an isotact construction of 83 % and an atactic construction of 17 %.

## Comparative Preparation Example 1

To 183 g of a methyl isobutyl ketone solution of 12 g of azobisisobutylonitrile (AIBN) was added 300 g of t-butyl methacrylate, and reacted with stirring at 90 °C for 10 hours in a nitrogen flow. Then, methyl isobutyl ketone was removed off by distillation, to which acetone was added and treated as generally described in Preparation Example 1. The obtain polymer was 280 g (93 % yield), and had a number average molecular weight (GPC) of 0.54 X $10^4$, an Mw/Mn ratio of 1.90 and a Tg of 68 °C.

The tacticity of the polymer was determined as generally described in Preparation Example 1 to find an isotact construction of 9 %, a heterotactic construction of 37 % and a syndiotactic construction of 54 %.

## Preparation of resist compositions

## Example 1

A solution having a solid content of 20 % by weight was prepared by mixing 4 g of the polymer of Preparation Example 1 in methyl isobutyl ketone, to which triphenylsulfonium hexafluoroantimonate was added in an amount of 15 % by weight based on the polymer amount. The obtained solution was rotary-coated at 2,000 rpm on a metal substrate to form a resist film with 2.0 micron. It was dried at 105 °C for 10 minutes. A positive film was contacted with the resist film and exposed to a ultrahigh pressure mercury lamp at a dose of 54 mJ/cm$^2$

or 108 mJ/cm². Then, it was heated at 105 °C for 10 minutes and developed with a 0.5 % sodium hydroxide solution at 50 °C for 60 seconds. The obtained positive images was observed by a microscope and its developing ability was evaluated. The results are shown in Table 1.

Example 2

A resist composition was prepared and evaluated as generally described in Example 1 with the exception that the polymer of Preparation Example 2 was employed instead of the polymer of Preparation Example 1. The results of the evaluations are shown in Table 1.

Example 3

A solution having a solid content of 20 % by weight was prepared by mixing 0.5 g of the polymer of Preparation 4 in methyl isobutyl ketone, to which triphenylsulfonium hexafluoroantimonate was added in an amount of 15 % by weight based on the polymers amount. Then, 3 wt % of anthraquinone was added thereto. The obtained solution was rotary-coated at 2,000 rpm on a metal substrate to form a resist film with 2.3 micron. It was dried at 105 °C for 10 minutes. A positive film was contacted with the resist plate and exposed to a ultrahigh pressure mercury lamp at 36 mJ/cm². It was then heated at 100 °C for 5 minutes and developed with a one % sodium metasilicate solution at 35 °C for 60 seconds to obtain positive images.

Comparative Example 1

A resist composition was prepared and evaluated as generally described in Example 1 with the exception that the polymer of Comparative Preparation Example 1 was employed instead of the polymer of Preparation Example 1. The results of the evaluations are shown in Table 1.

Table 1

| Irradiating amount($mJ/cm^2$) | Example 1 | Example 2 | Comparative Example 1 |
|---|---|---|---|
| 54<br>108 | Good<br>Good | Good<br>Good | Poor<br>Fairly good |

Good shows good positive images, Fairly good shows that the exposed portion was swollen with the developer and Poor shows that a change of refractive index which was caused by the change of the exposed portion to polymethacrylic acid was not seen.

Preparation of polymer

Preparation Example 5

The polymerization reaction was conducted by a breakable seal method in vacuo. A small amount of a tetrahydrofuran solution of alpha-methylstyrene tetramer was charged in a polymerization reaction vessel to rinse the vessel with the solution and the solution was removed. Then, 198 ml of tetrahydrofuran and 18 ml (3.0 mmol) of a benzene solution of 1,1-diphenylhexyl lithium were charged therein and cooled to -78 °C. To the content, 111 ml of a tetrahydrofuran solution of 123 mmol of t-butyl methacrylate was charged to start polymerization reaction. After mixing for 2 hours, 2 ml of methanol was added to terminate the reaction. The reaction solution was charged in a large amount of a methanol and water mixture (67/33 vol %) to precipitate the reaction product. After drying the reaction production, it was purified by a reprecipitation method with an acetone and water mixture. The obtained polymer was 18.2 g (100 % yield), and had a number average molecular weight (GPC) of $0.58 \times 10^3$, an Mw/Mn ratio of 1.57 and a Tg of 61 °C.

Preparation Example 6

A polymer was prepared as generally described in Preparation Example 5 with the exception that tetrahydrofuran was 256 ml, a benzene solution of 0.78 mmol of 1,1-diphenylhexyl lithium was 6.1 ml and a tetrahydrofuran solution of 151 mmol of t-butyl methacrylate was 66 ml. The obtained polymer was 21.5 g (100 % yield), and had a number average molecular weight (GPC) of 2.2 X 10$^4$, an Mw/Mn ratio of 1.28 and a Tg of 108 °C.

Preparation Example 7

A polymer was prepared as generally described in Preparation Example 5 with the exception that tetrahydrofuran was 260 ml, a benzene solution of 0.16 mmol of 1,1-diphenylhexyl lithium was 1.2 ml and a tetrahydrofuran solution of 149 mmol of t-butyl methacrylate was 40 ml. The obtained polymer was 21.3 g (100 % yield), and had a number average molecular weight (GPC) of 11 X 10$^4$, an Mw/Mn ratio of 1.19 and a Tg of 111 °C.

Preparation Example 8

To 192 g of a methyl isobutyl ketone solution of 20 g of t-butylperoxy-2-ethyl hexanoate (TBPO) was added 300 g of t-butyl methacrylate, and mixed at 90 °C for 6.5 hours in a nitrogen gas flow. After distilling off methyl isobutyl ketone, acetone was added thereto and treated as generally described in Preparation Example 5. The obtained polymer was 300 g (100 % yield), and had a number average molecular weight (GPC) of 0.57 X 10$^3$, an Mw/Mn ratio of 1.96 and a Tg of 70 °C.

Preparation Example 9

To 300 g of a toluene solution of 2.0 g of t-butylperoxy-2-ethyl hexanoate (TBPO) was added 300 g of t-butyl methacrylate, and mixed at 90 °C for 7 hours in a nitrogen gas flow. The obtained solution was treated as generally described in Preparation Example 8. The obtained polymer was 288 g (100 % yield), and had a number average molecular weight (GPC) of 2.2 X 10$^3$, an Mw/Mn ratio of 2.50 and a Tg of 101 °C.

Preparation Example 10

To 192 g of a methyl isobutyl ketone solution of 20 g of t-butylperoxy-2-ethyl hexanoate (TBPO) were added 200 g of t-butyl methacrylate and 100 g of methyl methacrylate, and mixed at 90 °C for 7 hours in a nitrogen gas flow. The obtained solution was treated as generally described in Preparation Example 8. The obtained polymer was 300 g (100 % yield), and had a number average molecular weight (GPC) of 0.89 X 10$^3$, an Mw/Mn ratio of 1.96 and a Tg of 74 °C.

Comparative Preparation Example 2

To 192 g of a toluene solution of 15 g of 2,2'-azobis(2,4-dimethylvaleronitrile) was added 300 g of t-butyl methacrylate, and mixed at 90 °C for 6 hours in a nitrogen gas flow. The obtained solution was treated as generally described in Preparation Example 8. The obtained polymer was 300 g (100 % yield), and had a number average molecular weight (GPC) of 0.54 X 10$^3$, an Mw/Mn ratio of 1.90 and a Tg of 68 °C.

Comparative Preparation Example 3

To 300 g of a toluene solution of 1.5 g of 2,2'-azobis(2,4-dimethylvaleronitrile) was added 300 g of t-butyl methacrylate, and mixed at 90 °C for 7 hours in a nitrogen gas flow. The obtained solution was treated as generally described in Preparation Example 8. The obtained polymer was 186 g (100 % yield), and had a number average molecular weight (GPC) of 1.9 X 10$^3$, an Mw/Mn ratio of 2.25 and a Tg of 97 °C.

Preparation of resist compositions

Example 4

A solution having a solid content of 20 % by weight was prepared by mixing 4 g of the polymer of Preparation Example 5 in methyl isobutyl ketone, to which triphenylsulfonium hexafluoroantimonate was added in an amount of 15 % by weight based on the polymer amount. The obtained solution was rotary-coated at 2,000 rpm on a metal substrate to form a resist film with 2.0 micron. It was dried at 105 °C for 10 minutes. A positive film was contacted with the resist film and exposed to a ultrahigh pressure mercury lamp at a dose of 36 mJ/cm$^2$ or 54 mJ/cm$^2$. Then, it was heated at 105 °C for 10 minutes and developed with a 0.5 % sodium hydroxide solution at 50 °C for 60 seconds. The obtained positive images was observed by a microscope and its developing ability was evaluated. The results are shown in Table 2.

Example 5

A resist composition was prepared and evaluated as generally described in Example 4 with the exception that the polymer of Preparation Example 6 was employed instead of the polymer of Preparation Example 5. The results of the evaluations are shown in Table 2.

Example 6

A resist composition was prepared and evaluated as generally described in Example 4 with the exception that the polymer of Preparation Example 7 was employed instead of the polymer of Preparation Example 5. The results of the evaluations are shown in Table 2.

Example 7

A resist composition was prepared and exposed as generally described in Example 4 with the exception that the polymer of Preparation Example 8 was employed instead of the polymer of Preparation Example 5. Then, it was heated at 105 °C for 10 minutes and developed with a 0.1 % sodium hydroxide solution at 50 °C for 60 seconds. The results of the developing ability are shown in Table 3.

Example 8

A resist composition was prepared and exposed and developed as generally described in Example 7 with the exception that the polymer of Preparation Example 9 was employed instead of the polymer of Preparation Example 8. The results of the developing ability are shown in Table 3.

Example 9

A resist composition was prepared and exposed and developed as generally described in Example 7 with the exception that the polymer of Preparation Example 10 was employed instead of the polymer of Preparation Example 8. The results of the developing ability are shown in Table 3.

Comparative Example 2

A resist composition was prepared and exposed as generally described in Example 4 with the exception that the polymer of Comparative Preparation Example 2 was employed instead of the polymer of Preparation Example 5. Then, it was heated at 105 °C for 10 minutes and developed with a 0.5 % sodium hydroxide solution at 50 °C for 60 seconds. The results of the developing ability are shown in Table 2. Or it was developed with a 0.1 % sodium hydroxide solution at 50 °C for 60 seconds. The results of the developing ability are shown in Table 3.

Comparative Example 3

A resist composition was prepared and exposed as generally described in Comparative Example 2 with the exception that the polymer of Comparative Preparation Example 3 was employed instead of the polymer of Comparative Preparation Example 2. Then, it was heated at 105 °C for 10 minutes and developed with a 0.5 % sodium hydroxide solution at 50 °C for 60 seconds. The results of the developing ability are shown in Table 2. Or it was developed with a 0.1 % sodium hydroxide solution at 50 °C for 60 seconds. The results of the developing ability are shown in Table 3.

Table 2

| No | Polymer No. | Irradiation 36 | amount $(mJ/cm^2)$ 54 |
|---|---|---|---|
| Ex. 4<br>Ex. 5<br>Ex. 6 | Prep. Ex. 5<br>Prep. Ex. 6<br>Prep. Ex. 7 | Good<br>Good<br>Good | Good<br>Good<br>Good |
| Comp. Ex. 2<br>Comp. Ex. 3 | Comp. Prep. Ex. 2<br>Comp. Prep. Ex. 3 | Poor<br>Poor | Poor<br>Fairly good |

Table 3

| No | Polymer No. | Irradiation 36 | amount $(mJ/cm^2)$ 54 |
|---|---|---|---|
| Ex. 7<br>Ex. 8<br>Ex. 9 | Prep. Ex. 8<br>Prep. Ex. 9<br>Prep. Ex.10 | Good<br>Good<br>Good | Good<br>Good<br>Good |
| Comp. Ex. 2<br>Comp. Ex. 3 | Comp. Prep. Ex. 2<br>Comp. Prep. Ex. 3 | Poor<br>Poor | Poor<br>Poor |

Good shows that good positive images are obtained, Fairly good shows that there are some remaining resin films on the exposed portion, and Poor shows that no images are obtained.

Preparation of polymer

Preparation Example 11

The polymerization reaction was conducted by a breakable seal method in vacuo. A small amount of a benzene solution of 1,1-diphenylhexyl lithium was charged in a polymerization reaction vessel to rinse the vessel with the solution and the solution was removed. Then, 485 ml of tetrahydrofuran and 16.5 ml (2.12 mmol) of a benzene solution of 1,1-diphenylhexyl lithium were charged therein and cooled to -78 °C. To the content, 113 ml of a tetrahydrofuran solution of 35.7 g of t-butyl methacrylate was charged to start polymerization reaction. After mixing for 2 hours, 2 ml of methanol was added to terminate the reaction. The reaction solution was charged in a large amount of a methanol and water mixture (1/1 vol %) to precipitate the reaction product. After drying the reaction production, it was purified by a reprecipitation method with an acetone, methanol and water mixture. The obtained polymer was 36.2 g (100 % yield), and had a number average molecular weight (GPC) of $1.7 \times 10^4$, an Mw/Mn ratio of 1.28 and a Tg of 97 °C.

Preparation Example 12

A reaction vessel was rinsed as generally described in Preparation Example 11, and charged with 505 ml of tetrahydrofuran and 11.2 ml of a benzene solution of 3.30 mmol 1,1-diphenylhexyl lithium. After cooling to -78 °C, 115 ml of a tetrahydrofuran solution of t-butyl methacrylate was added to start polymerization. After mixing for one hour, 3.1 ml of triethoxysilyl chloride and 4.7 ml of triethylamine were added to terminate the reaction. The reaction product was treated as generally described in Preparation Example 1. The obtained polymer was 34.3 g (100 % yield), and had a number average molecular weight (GPC) of $9.0 \times 10^4$, an Mw/Mn ratio of 1.36 and a Tg of 105 °C. An amount of terminal triethoxysilyl group was determined using 3.87 ppm methylene protons in $^1$H-NMR and its functionality was 0.98.

## Preparation Example 13

A reaction vessel was rinsed as generally described in Preparation Example 11, and charged with 218 ml of tetrahydrofuran, 1.2 g of alpha-methylstyrene and 16.2 ml of a tetrahydrofuran solution of 1.16 mmol sodium naphthalene. After mixing for 30 minutes and then cooling to -78 °C, 5.5 ml of a tetrahydrofuran solution of 1,1-diphenylethylene was added and mixed for 2 hours. Then, 61 ml of a tetrahydrofuran solution of t-butyl methacrylate was added. After mixing for one hour, 0.6 ml of isopropoxydimethylsilyl chloride and 0.7 ml of triethylamine were added to terminate the reaction. The reaction product was treated as generally described in Preparation Example 1. The obtained polymer was 11.5 g (100 % yield), and had a number average molecular weight (GPC) of $1.7 \times 10^4$ and an Mw/Mn ratio of 1.21. An amount of terminal triethoxysilyl group was determined using 3.87 ppm methylene protons in $^1$H-NMR and its functionality was 1.92.

## Comparative Preparation Example 4

To 183 g of a methyl isobutyl ketone solution of 12 g of azobisisobutylonitrile were added 200 g of t-butyl methacrylate and 100 g of methyl methacrylate, and mixed at 90 °C for 10 hours in a nitrogen gas flow. The obtained solution was treated as generally described in Preparation Example 11. The obtained polymer was 284 g (95 % yield), and had a number average molecular weight (GPC) of $0.61 \times 10^3$, an Mw/Mn ratio of 1.86 and a Tg of 78 °C.

## Preparation of resist compositions

## Comparative Example 4

A solution having a solid content of 20 % by weight was prepared by mixing 4 g of the polymer of Comparative Preparation Example 4 in methyl isobutyl ketone, to which triphenylsulfonium hexafluoroantimonate was added in an amount of 15 % by weight based on the polymer amount. The obtained solution was rotary-coated at 2,000 rpm on a metal substrate to form a resist film with 2.0 micron. It was dried at 105 °C for 10 minutes. A positive film was contacted with the resist film and exposed to a ultrahigh pressure mercury lamp at a dose of 0.8 J/cm$^2$. Then, it was heated at 105 °C for 10 minutes and developed with a 0.5 % sodium hydroxide solution at 50 °C for 60 seconds. The plate was rinsed with water and dried. The surface conditions of the obtained positive images and the developed portions were evaluated. The results are shown in Table 4.

## Comparative Example 5

A solution was prepared by mixing 50 mg of gamma-methacryloylpropyltrimethoxysilane with 5 ml of a methanol and water mixture (1/1 vol %), and rotary-coated on a glass plate. After drying, a resin composition prepared as generally described in Comparative Example 4 from the polymer of Preparation Example 11 was rotary-coated at 2,000 rpm to form a resist film with 2.0 micron. The plate was exposed at 30 mJ/cm$^2$ and developed as generally described in Comparative Example 4 and evaluated. The results are shown in Table 4.

## Example 10

A solution was prepared by dissolving 5 mg of the polymer of Preparation Example 12 in 5 ml of a methyl isobutyl ketone solution of 0.01 wt % acetic acid, and rotary-coated on a glass plate. After drying, a resin composition prepared as generally described in Comparative Example 4 from the polymer of Preparation Example 12 was rotary-coated at 2,000 rpm to form a resist film with 2.0 micron. The plate was exposed at 30 mJ/cm$^2$ and developed as generally described in Comparative Example 4 and evaluated. The results are shown in Table 4.

## Example 11

A same test was as generally described in Example 10, with the exception that the polymer of Preparation Example 13 was employed instead of the polymer of Preparation Example 12. The results are shown in Table 4.

Table 4

|  | Examples | | Comparative Examples | |
|---|---|---|---|---|
|  | 10 | 11 | 4 | 5 |
| Cracks of photoresist film after developing | Good | Good | Poor | Poor |
| Adhesiveness between the resist and the substrate | Good | Good | Poor | Fairly good |
| Wetability on developing portion when the aqueous resin composition was rotary-coated | Good | Good | Good | Poor (dewetting) |

## Claims

1. A resist composition comprising:
   (a) a polymer, having at least 70% of isotactic construction, as prepared from polymerisable monomers comprising a (meth)acrylate monomer having a t-butyl, benzyl, $\alpha$-methylbenzyl, $\alpha,\alpha$-dimethylbenzyl or trityl group; and
   (b) a photoactivator which generates an acid in response to light irradiation.

2. A resist composition comprising:
   (c) a polymer, having at least 70% of isotactic construction, as prepared from polymerisable monomers comprising a styrene monomer selected from p-(t-butoxycarbonyloxy)styrene, p-(t-butoxycarbonyloxy)-$\alpha$-methylstyrene, t-butyl p-vinylbenzoate and t-butyl (p-isopropenylphenyl)oxyacetate; and
   (b) a photoactivator as defined in claim 1.

3. A composition according to claim 1, wherein the polymer has no cyano group.

4. A composition according to claim 1 or claim 3, wherein the polymer has no terminal unsaturated group.

5. A composition according to any of claims 1, 3 and 4, wherein the polymer has a terminal alkoxysilyl group of the formula $-Si(R^1)_n(OR^2)_{3-n}$ wherein $R^1$ and $R^2$ are the same or different $C_{1-4}$ alkyl groups and n is 0, 1 or 2.

6. A composition according to any preceding claim, wherein the polymer is as prepared from the polymerisable monomers with copolymerisable $\alpha,\beta$-ethylenically-unsaturated monomers.

7. A composition according to claim 6, wherein the copolymerisable monomers are selected from (meth)acrylates, styrenes and mixtures thereof.

8. A composition according to any preceding claim, wherein the photoactivator is an onium salt.

9. A composition according to any preceding claim, which comprises 0.1 to 50% by weight, based on the weight of the polymer, of the photoactivator.

10. A photoresist composition comprising a substrate, an adhesive layer formed on the substrate, and a photoresist layer formed on the adhesive layer; wherein the adhesive comprises a polymer as prepared from polymerisable monomers as defined in any of claims 1, 3 and 4 and having a terminal group as defined in claim 5; and the photoresist comprises a composition according to any preceding claim.

European Patent
Office

**EUROPEAN SEARCH REPORT**

Application Number

| | DOCUMENTS CONSIDERED TO BE RELEVANT | | EP 91309659.0 |
|---|---|---|---|

| Category | Citation of document with indication, where appropriate, of relevant passages | Relevant to claim | CLASSIFICATION OF THE APPLICATION (Int. Cl.5) |
|---|---|---|---|
| D,X | US – A – 4 491 628<br>(ITO)<br>    * Claims 1-13 *<br>    -- | 1-4,<br>6-10 | G 03 F  7/039<br>G 03 F  7/075<br>C 08 F  2/50<br>C 08 F 20/18 |
| Y | US – A – 4 051 271<br>(FUJISHIGE)<br>    * Claims *<br>    -- | 1,6,10 | C 08 F 12/22 |
| P,X | EP – A – 0 440 374<br>(WAKO PURE CHEMICAL<br>INDUSTRIES LTD.)<br>    * Claims; page 4, line 51 –<br>      page 5, line 20 *<br>    ---- | 1-10 | |
| | | | TECHNICAL FIELDS<br>SEARCHED (Int. Cl.5)<br><br>G 03 F<br>H 01 L<br>C 08 F |

The present search report has been drawn up for all claims

| Place of search | Date of completion of the search | Examiner |
|---|---|---|
| VIENNA | 25-02-1992 | SCHÄFER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)

13